# EUROPÄISCHE PATENTSCHRIFT

(11) **EP 1 116 302 B1**
(45) Veröffentlichungstag und Bekanntmachung des Hinweises auf die Patenterteilung: **05.06.2002**
(21) Anmeldenummer: 99955702.8
(22) Anmeldetag: 09.09.1999
(51) Int. Cl.: H01R 12/20, H05K 5/02

(54) **VERBINDUNGSSYSTEM**
CONNECTING SYSTEM
SYSTEME DE LIAISON

(30) Priorität: 23.09.1998 DE 19843628
(43) Veröffentlichungstag der Anmeldung: 18.07.2001
(73) Patentinhaber: Infineon Technologies AG, 81669 München (DE)
(72) Erfinder: HÖRLLE, Andreas, D-14199 Berlin (DE); SCHULZ, Klaus, D-12309 Berlin (DE); MEYER-GÜLDEN, Frank, D-12357 Berlin (DE)
(74) Vertreter: Müller, Wolfram Hubertus, Dipl.-Phys.
(86) Internationale Anmeldenummer: DE9902922
(87) Internationale Veröffentlichungsnummer: WO0017963

(56) Entgegenhaltungen:
- US-A- 4 821 149
- US-A- 5 154 631
- US-A- 5 734 558

## Beschreibung

Die Erfindung liegt auf dem Gebiet der Montage elektronischer Bauteile oder Module, insbesondere elektrooptischer Module (sog. Transceiver). Bei der Montage derartiger Module auf Trägern, z.B. mit Leiterbahnen und Anschlußkontakten versehenen Leiterplatten, besteht anwenderseitig die Forderung nach verhältnismäßig frei und uneingeschränkt auf der Leiterplatte plazierbaren Modulen. Dabei werden Modulbauformen und geeignete mechanische Verbindungen gefordert, die - je nach verfügbarem Montageraum und Zugänglichkeit - ein einfaches horizontales Einbringen der Module in geeignete Halterungen erlauben oder eine vertikale Montage der Module zulassen.

In der US-PS 5,154,631 ist eine Montagevorrichtung offenbart, die Montageschienen aufweist, wobei ein planares Substrat als Träger einer elektronischen Schaltung entlang zweier gegenüberliegender Kanten Vorsprünge aufweist. Diese Vorsprünge können vertikal in die Montageschienen eingebracht werden, wobei das Substrat anschließend entlang schräger Schlitze in eine Endposition gleitet. Da das Substrat in der Endposition jedoch nicht gegen ein vertikales bzw. schräges Abziehen gesichert ist, eignet sich diese Montagevorrichtung jedoch nicht für die Montage der genannten elektrooptischen Module.

Aus der US-PS 5,734,558 gehen Modulvarianten mit jeweils einer Anschlußkontaktleiste hervor, die entweder an der Modulunterseite rechtwinklig hervorsteht oder eine die schmale Rückwand des in Einschubrichtung gesehen hinteren Modulbereichs durchdringt. Die erste Modulvariante erlaubt damit nur eine zu einer Halterung ausschließlich senkrechte Montage, bei der federnde elektrische Kontakte der modulseitigen Kontaktleiste vertikal in entsprechende kooperierende Kontakte einer halterungsseitigen Kontaktaufnahme eindringen. Diese Variante erfordert zur Montage bzw. Demontage einen entsprechenden Freiraum in vertikaler Richtung (nachfolgend auch als Y-Richtung bezeichnet) über der Halterung. Die andere Variante erlaubt nur eine Montage in einer zur Halterungsoberseite parallelen horizontalen Richtung (nachfolgend auch als Z-Richtung bezeichnet), die einen entsprechenden Freiraum vor der Halterung erfordert. Im übrigen ist bei beiden Varianten des Moduls eine präzise Führung des Moduls während der Verbindung mit der Halterung nicht vorgesehen.

Die Aufgabe der Erfindung besteht in der Schaffung eines Verbindungssystems zur lösbaren mechanischen Verbindung eines elektronischen Bauteils mit einer Halterung, das sowohl eine Montage ausschließlich in Z-Richtung als auch eine Montage mit einer Bewegung in Y-Richtung und anschließender Bewegung in Z-Richtung mit äußerst geringem erforderlichen Freiraum ermöglicht.

Diese Aufgabe wird erfindungsgemäß gelöst durch ein Verbindungssystem zur lösbaren mechanischen Verbindung eines elektronischen Bauteils mit einer Halterung, das zumindest einen Restweg bis in eine Endposition entlang einer zur Oberseite parallelen Einschubrichtung zurücklegt, wobei:
- das Verbindungssystem Halteschienen, die an den Längsseiten der Halterung ausgebildet sind, und mindestens zwei Haltebereiche an jeder Längsseite des Bauteils umfaßt, die während des Restweges zumindest teilweise mit den Halteschienen zusammenwirken,
- die Halteschienen mindestens je eine Lücke aufweisen, die ein zur Oberseite der Halterung senkrechtes vertikales Einsetzen der Haltebereiche erlauben, und
- der Restweg bis in die Endposition ausschließlich entlang einer zur Oberseite der Halterung parallelen Einschubrichtung erfolgt, wobei
- die Haltebereiche jeweils als Hintergreifungen ausgebildet sind, die in Einschubrichtung gesehen hintereinander angeordnet sind und während des Restweges (W) zumindest teilweise unter die Halteschienen (6, 7) greifen und
- die Lücken so ausgebildet sind, daß die in Einschubrichtung voreilenden Hintergreifungen die Lücken beim Montagevorgang passieren, ohne sich von der Halterung quer zur Einschubrichtung entfernen zu können.

Ein wesentlicher Vorteil des erfindungsgemäßen Verbindungssystems besteht darin, daß es je nach anwendungsspezifischen Gegebenheiten, insbesondere nach dem jeweils zur Montage bzw. Demontage zur Verfügung stehenden Raum und der gewünschten Anordnung der Halterung auf einem Träger, bedarfsweise sowohl eine ausschließlich in Z-Richtung verlaufende Montage bzw. Demontage, als auch eine im wesentlichen vertikale Montage mit einer Bewegung in Y-Richtung mit anschließender (geringer Rest-) Bewegung in Z-Richtung unter Zurücklegung des Restweges ermöglicht. Ein wesentlicher Aspekt ist dabei, daß beide Montagevarianten dem Verbindungssystem inhärent sind, so daß durchaus auch unterschiedliche Bewegungsabläufe bei der Montage und der Demontage realisiert werden können. Ein für die Anwendungsfreundlichkeit und Zuverlässigkeit wesentlicher Vorteil der Erfindung besteht darin, daß bei einer Montage in Z-Richtung durch die vorgesehene Ausbildung der Lücken in Bezug auf die voreilenden Hintergreifungen sichergestellt ist, daß die Hintergreifungen auch beim Vorbeibewegen an den Lücken die Halteschienen nicht - zumindest nicht ohne erheblichen Kraftaufwand - quer zur Einschubrichtung verlassen können. Damit gewährleistet das erfindungsgemäße Verbindungssystem trotz der alternativen Montage- bzw. Demontagemöglichkeiten eine geführte und zuverlässige Montagebewegung in Z-Richtung (Einschubrichtung).

Grundsätzlich könnte die zuverlässige Führung der voreilenden Hinterscheidungen bei Montage (ausschließlich) in Z-Richtung dadurch gewährleistet werden, daß die Breite der Hintergreifungen größer ist als die Lücken und beispielsweise die Hintergreifungen zur Montage in vertikaler Richtung in ihrer Breite elastisch vorübergehend vermindert werden können. Eine montagetechnisch bevorzugte Ausgestaltung sieht jedoch vor, daß die Breite der Lücken zumindest der Breite der in Einschubrichtung voreilenden Hintergreifungen entspricht.

Um beim Montagevorgang (ausschließlich) in 2-Richtung die voreilenden Hintergreifungen die Lücken zuverlässig passieren zu lassen, ist nach einer bevorzugten Ausgestaltung der Erfindung vorgesehen, daß die Lücken gegenüberliegender Halteschienen einen größeren Abstand aufweisen, als dem lichten Abstand der zugeordneten gegenüberliegenden voreilenden Hintergreifungen entspricht.

Insbesondere bei einer größeren Anzahl von Montage-Wechselspielen ist es vorteilhaft, wenn die Lücken Einführschrägen und/oder Entnahmeschrägen aufweisen, entlang derer die Hintergreifungen bei einer zur Halterung vertikalen Montage bzw.

Demontage des Bauteils gleiten. Besonders bevorzugt können die Hintergreifungen dabei federelastisch ausgebildet sein.

Die Erfindung wird nachfolgend anhand einer Zeichnung beispielhaft weiter erläutert; es zeigen:
Figur 1 eine Halterung;
Figuren 2 bis 4 in perspektivischer Ansicht eine Montagesequenz eines erfindungsgemäßen Verbindungssystems zwischen einem Bauteil und der Halterung nach Figur 1;
Figuren 5 bis 7 eine Montagesequenz aus perspektivischer Ansicht von der Bauteilunterseite;
Figuren 8a und 8b die Verhältnisse bei einer Montage in Y-Z-Richtung und
Figur 9 einen Ausschnitt des Verbindungssystems zur Erläuterung der Verhältnisse bei einer Montage nur in Z-Richtung.

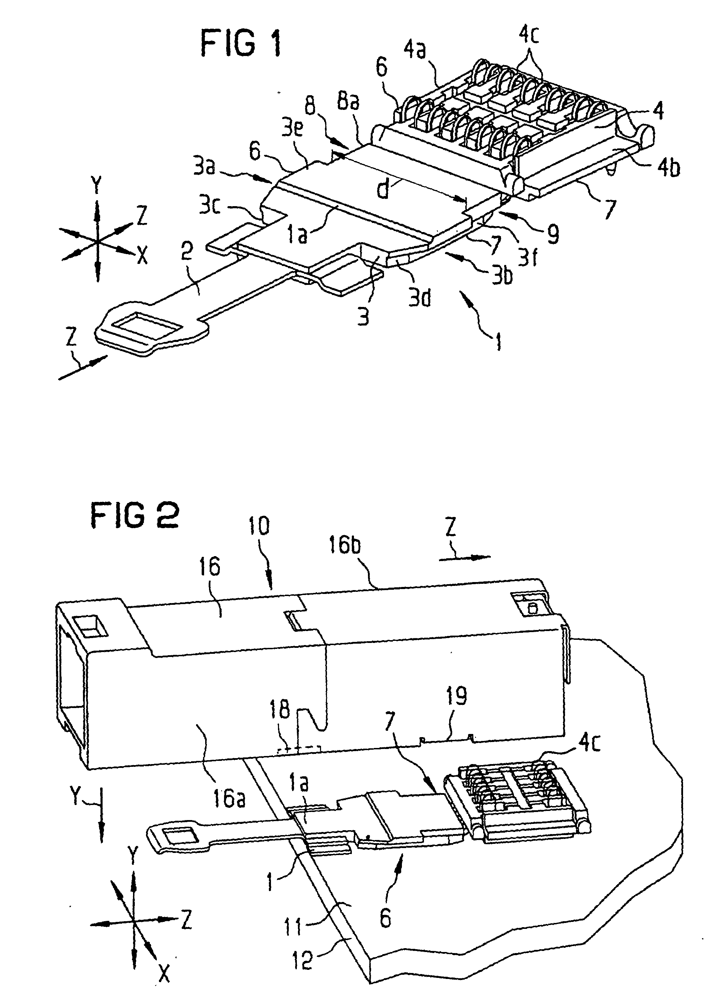

Figur 1 zeigt eine Halterung 1, die im wesentlichen drei Komponenten umfaßt: In Längsachsenrichtung der Halterung gesehen eine Verriegelungszunge 2, einen Halteblock 3 und ein Anschlußteil 4. Die Längachse der Halterung 1 fällt mit der gemäß Figur 1 als Z-Richtung definieren horizontalen und parallel zur Oberseite 1a der Halterung 1 verlaufenden Einschubrichtung Z zusammen. Der Halteblock 3 weist an seinem in Z-Richtung gesehen vorderen Ende seiner Längsseiten 3a, 3b Einführschrägen oder Fasen 3c, 3d für ein noch näher beschriebenes Bauteilgehäuse bzw. bauteilseitige Hintergreifungen auf. An die Fasen 3c, 3d schließen sich an den Längsseiten 3a, 3b ausgebildete Abschnitte 3e, 3f beiderseits verlaufender paralleler Halteschienen 6, 7 an. Die Halteschienen 6, 7 sind im rückwärtigen Bereich des Halteblocks 3 durch Ausnehmungen oder Lücken 8, 9 unterbrochen. Die Lücken reichen bis zu dem Anschlußteil 4, an dessen Schmalseiten Abschnitte 4a, 4b die Schienen 6, 7 fortsetzen.

Anhand der Figuren 2 bis 4 wird nunmehr eine Montagesequenz eines Bauteils 10 auf der Halterung 1 der in der Figur 1 gezeigten Art erläutert. Die Halterung ist dabei auf der Oberseite 11 einer andeutungsweise dargestellten Leiterplatte 12 montiert und mit nicht dargestellten elektrischen Zuleitungen kontaktiert. Bei der nachfolgend erläuterten Montagevariante setzt sich die Montage aus einer vertikalen Absenkbewegung senkrecht zur Oberseite 1a der Halterung 1 (Y-Richtung) und einer anschließenden, vergleichsweise geringen Einschubbewegung in Z-Richtung oder Einschubrichtung Z zusammen.

Das Bauteil 10 weist ein Bauteilgehäuse 16 auf, das an seinen Längsseiten in Einschubrichtung Z gesehen je zwei hintereinander angeordnete Hintergreifungen aufweist. Bei der Ansicht gemäß Figur 2 sind nur die Hintergreifungen 18, 19 sichtbar, die an der dem Betrachter zugewandten Bauteilgehäuseseite 16a ausgebildet sind. Gegenüberliegend auf der anderen Längsseite 16b des Gehäuses 16 sind entsprechende, den Hintergreifungen 18, 19 zugewandte gleichartige Hintergreifungen ausgebildet. In Figur 2 sind federnde Anschlußkontakte 4c (vgl. auch Figur 1) des Anschlußteils 4 erkennbar, die mit entsprechenden Anschlußkontaktflächen auf der Unterseite einer in dem Gehäuse 16 angeordneten Leiterplatte im montierten Endzustand in Kontakt sind. Die Kontakte 4c üben damit eine vertikale Federkraft in Y-Richtung aus, die im noch näher erläuterten Zusammenwirken zwischen den Hintergreifungen 18, 19 und den Halteschienen 6, 7 der Halterung 1 aufgenommen wird.

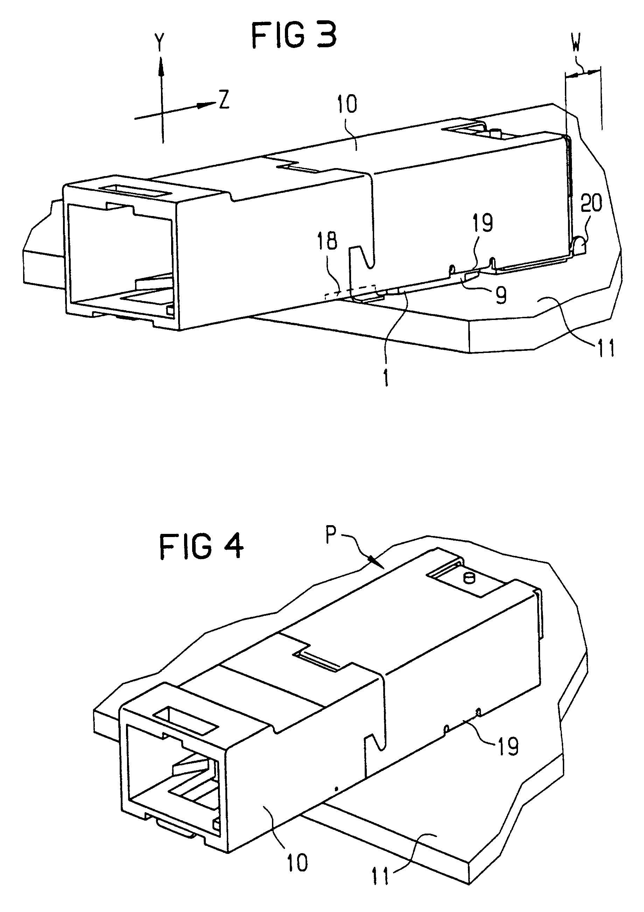

Figur 3 zeigt das Bauteil 10 und die Halterung 1 in einem fortgeschrittenen Montagestadium, in dem die Montagebewegung in Y-Richtung bereits abgeschlossen ist, aber die verbleibende Montage in Z-Richtung noch bevorsteht. Mit der verbleibenden restlichen Montagebewegung wird ein Restweg w bis in die Endposition (Figur 4) zurückgelegt. Die Hintergreifungen 18, 19 sind dabei bereits auf das Niveau der unteren, der Trägeroberseite 11 zugewandten Seite der Schienen 6, 7 abgesenkt. Die Hintergreifung 19 hat dabei die Lücke 9 durchdrungen. Bei der anschließenden (Rest-) Montagebewegung in Z-Richtung wird das Bauteil 10 soweit nach hinten verschoben, bis es die in Figur 4 gezeigte Endposition P erreicht. Dabei wird ein in Figur 3 noch erkennbarer hinterer Betätigungsnocken 20 mittels einer nicht näher dargestellten Kulissenführung derart bewegt, daß die Kontakte 4c (Figur 2) zunächst aus der Bewegungsebene der bauteilseitigen Leiterplatte entfernt werden und bei Erreichen der Endposition P (Figur 4) auf die zugeordneten Anschlußkontaktflächen zurückfedern. Die Gegenkraft zu den dabei ausgeübten Federkräften wird wie eingangs bereits erwähnt durch den Eingriff der Hintergreifungen hinter die zugeordneten Schienen aufgebracht.

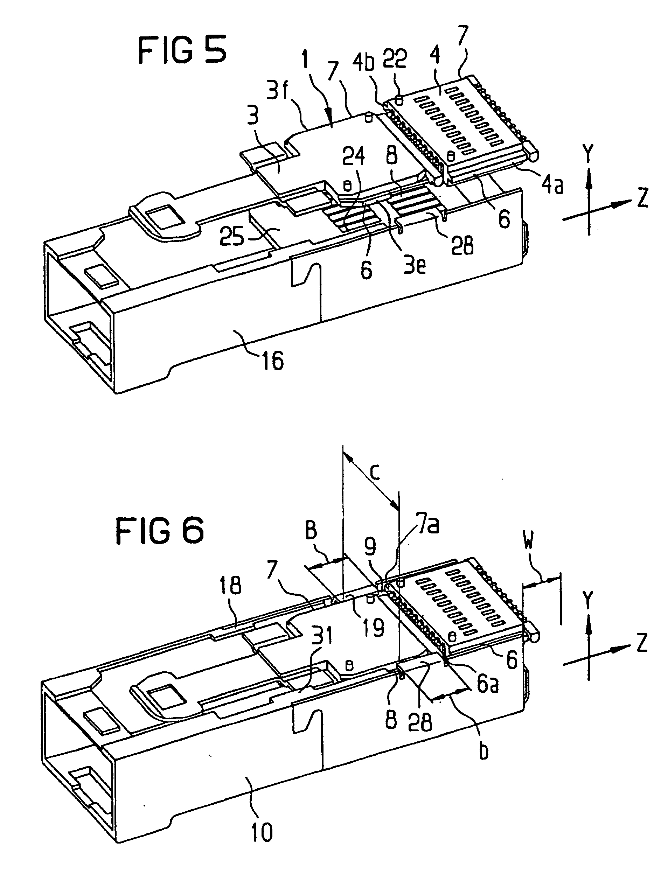

Zur ergänzenden Erläuterung des zuvor beschriebenen Montagevorgangs sind Einzelheiten des Verbindungssystems in den Figuren 5, 6, und 7 in einer perspektivischen Ansicht von der Unterseite der Anordnung her (unter Weglassung des Trägers 12 aus Figur 2) dargestellt. Die Unterseite der Halterung 1 weist im Bereich des Halteblocks 3 und des Anschlußteils 4 Zentrierzapfen 22 zur Positionierung der Halterung auf dem Träger 11 (Figur 2) auf. Ferner sind die Abschnitte 3e, 3f und 4a, 4b der Schienen 6, 7 erkennbar. Ferner sind die Anschlußkontaktflächen 24 einer in dem Gehäuse 16 enthaltenen Leiterplatte 25 dargestellt, die im montierten Endzustand mit den Kontakten 4c kooperieren. Die Darstellung in Figur 5 zeigt die in der Halteschiene 6 vorgesehene Lücke 8, die im Zuge der weiteren Montage von der der (in Figur 2 gezeigten) Hintergreifung 19 gegenüberliegenden Hintergreifung 28 durchdrungen wird.

Figur 6 zeigt das Bauteil 10 nach Abschluß der Montagebewegung in Y-Richtung und bevor das Bauteil 10 in Z-Richtung um den Restweg w in seine Endposition bewegt wird. In diesem Zustand haben die in Einschubrichtung Z gesehen hinteren Hintergreifungen 19, 28 (nachfolgend in bezug auf die Einschubrichtung Z auch als voreilende Hintergreifungen bezeichnet) die ihnen jeweils zugeordnete Lücke 8, 9 bereits durchdrungen und liegen an den Unterseiten 6a, 7a, der Halteschienen 6, 7 an. Die breite b der Lücken 7, 8 ist weiter bemessen als die Breite B der Hintergreifungen 19, 28.

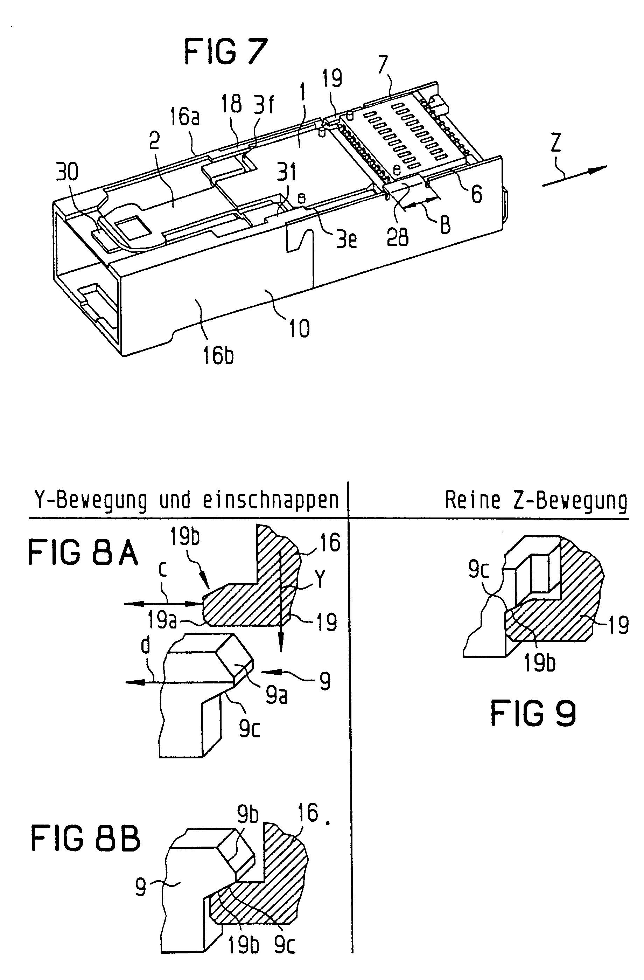

Figur 7 zeigt das Bauteil 10 und die Halterung 1 kurz vor Erreichen der Montageendposition, in der eine korrespondierende Verriegelungsnase 30 die vordere Ausnehmung der Verriegelungszunge 2 durchdringt, um das Bauteil gegenüber der Halterung in Z-Richtung zu verriegeln. Die in Z-Richtung voreilenden Hintergreifungen 19, 28 liegen dabei bereits zu einem erheblichen Anteil ihrer Breite B auf den Unterseiten 6a, 7a der Schienen 6, 7 auf und hintergreifen damit die Schienen 6, 7. Die in Einschubrichtung Z gesehen weiter vorne an den Längsseiten 16a, 16b des Gehäuses ausgebildeten Hintergreifungen 18, 31 sind auf die Unterseiten der Abschnitte 3e, 3f der Halterung 1 in entsprechender Weise aufgelaufen.

Die Verhältnisse beim Aufsetzten des Bauteils 10 auf die Halterung 1 sind hinsichtlich der Hintergreifungen schematisch detailliert in den Figuren 8a und 8b dargestellt. Beim Absenken des Bauteils bzw. dessen Gehäuses 16 in Y-Richtung gelangt eine Anlaufschräge 19a einer der beispielhaft dargestellten Hintergreifungen (z.B. 19) in Körperkontakt mit einer Einführschräge 9a der Lücke 9 (vgl. auch Figur 1). Dadurch werden die gegenüberliegenden Hintergreifungen 19, 28 (Figur 6) in ihrem Abstand c auf einem Abstand d erweitert, der zwischen den vertikalen Flächen der gegenüberliegenden nasenartigen Vorsprünge (gezeigt ist hier nur der Vorsprung 9b) der Lücken 8, 9 besteht. Dabei federn die einander zugewandten Hintergreifungen 19, 28 elastisch auf und schnappen hinter dem nasenartigen Vorsprung 9b im Bereich der Lücke 9 ein. Dabei liegt dann eine weitere Schräge 19b an einer zugeordneten Schräge 9c des Vorsprunges 9b an. Auf diese Weise kann das Bauteil - allerdings nur mit gewissem vertikalen Kraftaufwand in Y-Richtung - aus dieser Position auch wieder vertikal demontiert werden.

Eine alternative Montageart wird nachfolgend unter erneuter Bezugnahme auf die Figuren 1 und 6 sowie 9 erläutert. Alternativ ist nämlich das Bauteil auch ausschließlich in Z-Richtung montierbar bzw. demontierbar. Bei der reinen Z-Bewegung werden die voreilenden Hintergreifungen 19, 28 bereits im frontseitigen Bereich des Halteblocks 3 über die Fasen 3c, 3d in die gewünschte Bewegungsebene unterhalb der Abschnitte 3a, 3b der Halteschienen 6, 7 geführt. Die voreilenden Hintergreifungen 19, 28 passieren dabei die Lücken 8, 9, ohne aus diesen in vertikaler Richtung (zumindest bei Einwirken normaler Montagekräfte) die Halterung wieder verlassen zu können. Wie dazu Figur 9 andeutet, sind nämlich die Hintergreifungen (beispielhaft ist nur die eine Hintergreifung 19 gezeigt) mit der Schräge 19b weiterhin in Körperkontakt mit der Schräge 9c im Bereich der Lücke 9. Dadurch ist gewährleistet, daß das Bauteil auch bei ausschließlicher Montage in Z-Richtung stets zuverlässig und hochpräzise auf die Halterung bis in die Endposition geführt ist. Entsprechende Verhältnisse liegen vor, wenn das Bauteil ausschließlich in Z-Richtung demontiert wird.

## Patentansprüche

1. Verbindungssystem zur lösbaren mechanischen Verbindung eines elektronischen Bauteils (10) mit einer Halterung (1), das zumindest einen Restweg (W) bis in eine Endposition (P) zurücklegt, wobei:
- das Verbindungssystem Halteschienen (6, 7), die an den Längsseiten der Halterung (1) ausgebildet sind, und mindestens zwei Haltebereiche an jeder Längsseite des Bauteils (10) umfaßt, die während des Restweges (W) zumindest teilweise mit den Halteschienen (6, 7) zusammenwirken,
- die Halteschienen (6, 7) mindestens je eine Lücke (8, 9) aufweisen, die ein zur Oberseite der Halterung (1a) senkrechtes Einsetzen der Haltebereiche erlauben,
**dadurch gekennzeichnet,**
**daß** der Restweg (W) bis in die Endposition (P) ausschließlich entlang einer zur Oberseite (1a) der Halterung (1) parallelen Einschubrichtung (Z) erfolgt, wobei
- die Haltebereiche jeweils als Hintergreifungen (18, 19; 31, 28) ausgebildet sind, die in Einschubrichtung (Z) gesehen hintereinander angeordnet sind und während des Restweges (W) zumindest teilweise unter die Halteschienen (6, 7) greifen und
- die Lücken (8, 9) so ausgebildet sind, daß die in Einschubrichtung (Z) voreilenden Hintergreifungen (18, 19) die Lücken (8, 9) beim Montagevorgang passieren, ohne sich von der Halterung (1) quer zur Einschubrichtung (Z) entfernen zu können.

2. Verbindungssystem nach Anspruch 1,
**dadurch gekennzeichnet, daß** die Lücken (8, 9) gegenüberliegender Halteschienen (6, 7) einen größeren Abstand (d) aufweisen, als dem lichten Abstand (c) der zugeordneten gegenüberliegenden voreilenden Hintergreifungen (19, 28) entspricht.

3. Verbindungssystem nach Anspruch 2,
**dadurch gekennzeichnet, daß**
die Lücken (9) Einführschrägen (9a) und/oder Entnahmeschrägen (9c) aufweisen, entlang derer die Hintergreifungen (19) bei einer zur Halterung (1) vertikalen Montage bzw. Demontage des Bauteils (10) gleiten.

4. Verbindungssystem nach einem der vorhergehenden Ansprüche,
**dadurch gekennzeichnet, daß**
die Hintergreifungen (18, 19; 29, 32) federelastisch ausgebildet ist.

## Claims

1. Connection system for the releasable mechanical connection of an electronic component (10) to a holder (1) which covers at least a residual amount of travel (W) before it arrives in an end position, in which:
- the connection system has holding rails (6, 7) which are formed on the longitudinal sides of the holder (1) and comprise two holding regions on each longitudinal side of the component (10), which interact at least partially with the holding rails (6, 7) during the residual travel (W),
- the holding rails (6, 7) have at least one gap (8, 9) each, allowing a vertical insertion of the holding regions perpendicularly in relation to the upper side of the holder (1a),
**characterized in that**
- the residual travel (W) into the end position (P) takes place exclusively along a pushing-in direction (Z) parallel to the upper side (1a) of the holder (1), in which
- the holding regions are respectively designed as rear-engagement means (18, 19; 31, 28) which, seen in the pushing-in direction (Z), are arranged one behind the other and, during the residual travel (W), grip at least partially under the holding rails (6, 7) and
- the gaps (8, 9) are formed in such a way that the rear-engagement means (18, 19) that are leading in the pushing-in direction (Z) pass the gaps (8, 9) during the mounting operation without being able to come away from the holder (1) transversely in relation to the pushing-in direction (Z).

2. Connection system according to claim 1,
**characterized in that** the gaps (8, 9) of holding rails (6 7) lying opposite one another are at a greater spacing (d) than the clear spacing (c) of the assigned leading rear-engagement means (19, 28) lying opposite one another.

3. Connection system according to claim 2,
**characterized in that** the gaps (9) have lead-in slopes (9a) and/or removal slopes (9c), along which the rear-engagement means (19) slide during mounting or removal of the component (10) vertically in relation to the holder (1).

4. Connection system according to one of the preceding claims, **characterized in that** the rear-engagement means (18, 19; 29, 32) are of a resilient design.

## Revendications

1. Système de liaison destiné à la liaison mécanique amovible d'un composant électronique (10) avec une fixation (1), lequel composant parcourt au moins un trajet restant (W) pour atteindre une position finale (P) le long d'une direction de l'enfichage parallèle au côté supérieur, où
- le système de liaison comprend des rails de fixation (6, 7) qui sont formés sur les grands côtés de la fixation (1) et, sur chacun des grands côtés du composant (10), au moins deux zones de fixation qui interagissent au moins partiellement avec les rails de fixation (6, 7) pendant le trajet restant (W),
- chacun des rails de fixation (6, 7) présente au moins une encoche (8, 9) qui permet une introduction à la verticale des zones de fixation perpendiculairement au côté supérieur de la fixation (1a),
**caractérisé en ce que**
le trajet restant (W) pour atteindre la position finale (P) a lieu exclusivement le long d'une direction d'enfichage (Z) parallèle au côté supérieur (1a) de la fixation (1), où
- les zones de fixation sont chacune formées en tant que griffes arrière (18, 19 ; 31, 28) lesquelles sont disposées les unes derrière les autres quand on les regarde en direction d'enfichage (Z) et s'agrippent au moins en partie sous les rails de fixation (6, 7) au cours du trajet restant (W) et
- les encoches (8, 9) sont formées de telle sorte que les griffes arrière (18, 19) avançant en direction d'enfichage (Z) passent par les encoches (8, 9) lors de l'opération de montage sans pouvoir s'écarter obliquement de la fixation (1) par rapport à la direction d'enfichage (Z).

2. Système de liaison selon la revendication 1 **caractérisé en ce que** les encoches (8, 9) des rails de fixation (6, 7) qui se trouvent en face présentent un écart (d) plus grand que l'écart intérieur (c) des griffes arrière avançantes (19, 28) qui correspondent en face.

3. Système de liaison selon la revendication 2 **caractérisé en ce que** les encoches (9) présentent des inclinaisons pour l'introduction (9a) ou pour le retrait (9c), que le long de celles-ci glissent les griffes arrière (19) lors d'un montage ou d'un démontage du composant (10) verticalement par rapport à la fixation (1).

4. Système de liaison selon l'une des revendications précédentes **caractérisé en ce que** les griffes arrière (18, 19 ; 29 ; 32) sont élastiques.
